# EUROPÄISCHE PATENTSCHRIFT

(11) **EP 2 867 623 B1**
(45) Veröffentlichungstag und Bekanntmachung des Hinweises auf die Patenterteilung: **10.05.2017**
(21) Anmeldenummer: 13732161.8
(22) Anmeldetag: 27.06.2013
(51) Int. Cl.: G01D 5/20, G01D 11/24

(54) **SENSOREINRICHTUNG**
SENSOR DEVICE
DISPOSITIF CAPTEUR

(30) Priorität: 27.06.2012 DE 102012012680
(43) Veröffentlichungstag der Anmeldung: 06.05.2015
(73) Patentinhaber: Hartmann, Eva, 71263 Weil der Stadt (DE)
(72) Erfinder: HARTMANN, Steven, 71272 Renningen (DE)
(74) Vertreter: Wolf, Eckhard
(86) Internationale Anmeldenummer: PCT/EP2013/063571
(87) Internationale Veröffentlichungsnummer: WO 2014/001479

(56) Entgegenhaltungen:
- WO-A1-2011/030142
- DE-A1- 2 602 045
- DE-A1-102009 048 248
- US-B1- 6 617 845

## Beschreibung

Die Erfindung betrifft eine Sensoreinrichtung mit einem Gehäuse für einen mindestens eine Spule aufweisenden, vorzugsweise induktiven Sensor zur berührungslosen Abstandsmessung zu elektrisch leitfähigen Objekten, wobei der Sensor eine maximale Betriebstemperatur nicht überschreiten darf.

Derartige Sensoren sind als Einheit im Handel verfügbar und umfassen in einem Kapselgehäuse mindestens eine Induktionsspule und elektronische Komponenten wie einen Oszillator, einen Integrator sowie einen Verstärker zum Beaufschlagen der mindestens einen Spule mit einer Wechselspannung. In der Nähe von leitenden Objekten erfährt das von der Spule erzeugte Wechselfeld eine Dämpfung, aus deren Größe letztlich auf den Abstand zu dem leitenden Gegenstand geschlossen werden kann. Eine zuverlässige Messung ist jedoch nur in einem begrenzten Abstand zu dem leitenden Objekt möglich, so dass beispielsweise bei einer Füllstandsmessung von Metallschmelztiegeln o. dgl. der Messabstand nicht so groß gewählt werden kann, dass der Sensor seine zugelassene Temperaturbelastung, typischerweise nicht mehr als etwa 80 °C, einhalten könnte. Um den Sensor vor zu starker Wärmeeinwirkung zu schützen und gleichzeitig den erforderlichen Messabstand einhalten zu können, wurde in der DE 10 2009 048 248 A1 bereits eine Anordnung des Sensors in einem Gehäuse mit Kühlmitteln vorgeschlagen.

Die Aufgabe der vorliegenden Erfindung besteht darin, eine Einrichtung der genannten Art weiter zu entwickeln und insbesondere hinsichtlich der zulässigen Höchsttemperatur des zu messenden Objekts zu verbessern.

Zur Lösung dieser Aufgabe wird die in Patentanspruch 1 angegebene Merkmalskombination vorgeschlagen. Vorteilhafte Ausgestaltungen und Weiterentwicklungen der Erfindung ergeben sich aus den abhängigen Ansprüchen.

Die Erfindung geht vor allem von dem Gedanken aus, zur Erhöhung des Messabstands den Spulendurchmesser zu vergrößern, der bislang durch das Kapselgehäuse des Sensors begrenzt ist. Erfindungsgemäß wird daher vorgeschlagen, dass in dem Gehäuse ein Kühlkörper einerseits als Träger für die mindestens eine elektrische Spule des Sensors und andererseits als Verbindungselement zu einem Wärmeleitsystem zum Ableiten von Wärme zu einen dem zu messenden Objekt abgewandten Bereich des Gehäuses angeordnet ist. Das ohnehin in dem Gehäuse vorhandene, zwischen einem Messfenster des Gehäuses und dem Kapselgehäuse des Sensors angeordnete Bauteil "Kühlkörper" übernimmt damit eine zusätzliche Funktion. Da die Spule die am wenigsten temperaturempfindliche Komponente des Sensors ist, ist es für deren Kühlung hinreichend, wenn sie beispielsweise eng anliegend auf den Außenumfang des Kühlkörpers gewickelt ist.

Von großer Bedeutung bei gegenüber dem Stand der Technik erhöhten Messtemperaturen ist eine thermisch gute Ankopplung des Kühlkörpers an mindestens ein Wärmerohr der Sensoreinrichtung, welches Wärme vom spulenseitigen Ende des Gehäuses zum dem Objekt abgewandten Ende des Gehäuses transportiert. Bevorzugt ist der Kühlkörper mittels einer Lötverbindung mit dem mindestens einen Wärmerohr verbunden. In unterschiedlichen Varianten der Erfindung kann eine Mehrzahl kleinerer Wärmerohre anstatt eines einzelnen, vergleichsweise großen Wärmerohrs verwendet werden.

Um eine einfache Demontage des Kühlkörpers zum Austausch von Sensorkomponenten zu ermöglichen, ist gemäß einer alternativen Ausgestaltung der Erfindung der Kühlkörper nicht direkt mit dem Wärmerohr verbunden, sondern mit einem Koppelelement, das seinerseits mit dem Wärmerohr koppelbar ist. Zweckmäßig ist das Koppelelement dann mit dem Wärmerohr verschraubt oder verrastet oder mittels einer Bajonettverbindung verbunden. Der Kühlkörper seinerseits kann dabei mit dem Koppelelement durch eine Lötverbindung oder eine Schrumpfverbindung verbunden sein.

Um eine mechanische Belastung des Kühlkörpers bzw. der Lötverbindung bei der Montage der Kombination aus Kühlköper und Koppelelement an dem Wärmerohr zu vermeiden, weist das Koppelelement in bevorzugter Ausgestaltung der Erfindung Mittel zum Ansetzen eines Werkzeugs auf. Beispielsweise kann das Koppelelement Flächen zum Ansetzen eines Schraubenschlüssels oder mindestens eine Vertiefung zum Ansetzen eines Haken- oder Stiftschlüssels aufweisen. Zusätzlich kann eine mechanische Sicherung gegen ungewolltes Lösen oder Wiederöffnen der Verbindung zwischen dem Koppelelement und dem Wärmerohr vorgesehen sein, da die Sensoreinrichtung Vibrationen ausgesetzt sein kann und chemische Sicherungsmittel für Schraubverbindungen einerseits den Wärmefluss behindern könnten und andererseits den hohen Einsatztemperaturen der Sensoreinrichtung nicht standhalten.

In weiterer Ausgestaltung der Erfindung kann die mindestens eine Spule galvanisch, etwa über Anschlussdrähte oder Leiterbahnen mit einer außerhalb des Wärmeleitsystems angeordneten Elektronikeinheit zum Beaufschlagen der mindestens einen Spule mit einer elektrischen Wechselspannung ver-bunden sein. Die Elektronik kann damit in einen kühlen Bereich verlagert werden, da sie nur bis etwa 80 °C belastbar ist, während die Spule bis etwa 300 °C belastbar ist.

Die Ankopplungsfläche des Kühlkörpers bzw. des Koppelelements an das Wärmerohr kann axial und/oder radial ausgerichtet sein und beispielsweise ringförmig ausgebildet sein.

Der den mit am höchsten Temperaturen ausgesetzte Kühlkörper besteht in bevorzugter Ausgestaltung der Erfindung aus einer Aluminiumnitridkeramik, alternativ auch aus Ferrit oder einem Verbundwerkstoff umfassend umfassend Ferrit und kohlenstoffhaltiges Material, insbesondere Graphit. Aluminiumnitridkeramik weist den Vorteil höchster Temperaturbelastbarkeit auf, währen ein Ferritwerkstoff das Spulenfeld verstärkt und damit einen noch größeren Messabstand erlaubt, als bereits durch den erfindungsgemäß vergrößerten Spulendurchmesser ermöglicht wird. Die Sensoreinrichtung ist damit an verschiedenste Messumgebungen anpassbar.Gemäß der Erfindung besteht der Kühlkörper aus mindestens zwei Schichten, auf und/oder zwischen denen die Spule in ebener Konfiguration angeordnet ist.

In Abhängigkeit von unterschiedlichen verwendeten Messverfahren kann eine einzige Spule vorgesehen sein und die Messung auf einer Verstimmung oder Dämpfung eines die Spule umfassenden Schwingkreises beruhen, oder es können eine Sendespule und zwei Empfangsspulen zur Anwendung eines Differenzmessverfahrens vorgesehen sein, wobei die drei Spulen axial in der Reihenfolge Empfangsspule-Sendespule-Empfangsspule angeordnet sind.

In einer weiteren alternativen Ausgestaltung der Erfindung werden zwei ringförmig geschlossene Mäanderspulen verwendet, die hinsichtlich ihrer Mäander deckungsgleich oder um einen Winkel zueinander versetzt angeordnet sind. Derartige Spulenanordnungen sind grundsätzlich bekannt und in abgewandelter aber funktionsähnlicher Geometrie beispielsweise in der DE 10 2009 021 804 A1 oder DE 10 2009 029 928 A1 für den Anwendungsfall eines Metalldetektors beschrieben. Vorliegend können die aufgrund ihrer Leistungscharakteristik bevorzugten Mäanderspulen ebenfalls durch abgewandelte Geometrien ersetzt werden.

Die zwei Spulen sind zweckmäßig als Kupferprintspulen auf je einer Seite eines scheibenförmigen Kunststoffsubstrats, vorzugsweise eines FR4 glasfaserverstärkten Epoxylaminatsubstrats, oder eines Aluminiumnitrid Keramiksubstrats ausgebildet.

Bei einer weiteren besonders bevorzugten Ausführungsform der Erfindung weist der Kühlkörper eine zentrale Durchtrittsbohrung auf, durch die ein federbelastetes Zugorgan hindurchtritt, das einen aus zwei je auf einer Seite eines Substrats angeordneten Spulen bestehenden Spulenverbund gegen eine Stirnfläche des Kühlkörpers drückt. Das Anpressen des Spulenverbunds gegen den Kühlkörper weist den Vorteil auf, dass keine alterungsbedingten Kontaktbeeinträchtigungen wie beispielsweise eine Alterung und Versagen einer Klebstoffverbindung auftreten. Weiterhin werden durch Temperaturwechsel auftretende Spannungen durch die Feder kompensiert und die Montagezeit der Sensoreinrichtung wird verkürzt, da Aushärtezeiten einer Klebverbindung entfallen. Zweckmäßig ist zur Verbesserung des Wärmeübergangs eine Wärmeleitfolie zwischen dem Spulenverbund und dem Kühlkörper angeordnet.

In vorteilhafter Ausgestaltung dieser Ausführungsform ist das Zugorgan durch vier Drahtabschnitte gebildet, die durch den Spulenverbund hindurchtreten und mit Anschlüssen der zwei Spulen elektrisch kontaktiert sind. Die Drahtabschnitte erfüllen damit sowohl die Funktion des Zugorgans als auch die Funktion der elektrischen Verbindung der Spulen mit der Sensorelektronik. Um einen Kurzschluss zwischen den vier Drahtabschnitten untereinander oder mit den weiteren Komponenten der Sensoreinrichtung zu vermeiden ist in bevorzugter Ausgestaltung der Erfindung eine in der Durchtrittsbohrung des Kühlkörpers angeordnete, aus einem elektrisch isolierenden Material, vorzugsweise aus Aluminiumoxidkeramik, bestehenden Führungshülse für die vier Drahtabschnitte vorgesehen. Die Führungshülse weist zweckmäßig vier voneinander getrennte Durchtrittskanäle für je einen der Drahtabschnitte auf.

Um die Zugkraft der Feder auf den Spulenverbund zu übertragen, treten die dem Spulenverbund abgewandten Enden der vier Drahtabschnitte in vorteilhafter Ausgestaltung der Erfindung unter Zwischenschaltung eines Federpakets durch eine Arretierscheibe hindurch und sind mit dieser verbunden, vorzugsweise verlötet. Das Federpaket umfasst vorteilhaft eine Schraubenfeder und zwei die Schraubenfeder endseitig begrenzende Scheiben. Die Führungshülse für die Drahtabschnitte tritt auch durch das Federpaket hindurch um dort einen möglichen Kurzschluss mit den Drahtabschnitten zu verhindern.

Der Kühlkörper dieser Ausführungsform der Erfindung besteht bevorzugt aus Aluminiumnitridkeramik. Um ein Eindringen von Partikeln in den Bereich des Spulenverbunds und eine ungewollte Verschiebung des Spulenverbunds bei der Montage zu vermeiden, ist der Spulenverbund zusammen mit einem Endbereich des Kühlkörpers in vorteilhafter Ausgestaltung der Erfindung mit einem wärmeleitfähigen Schutzüberzug versehen. Um einen möglichst günstigen Wärmeübergang zu erreichen, kann der Schutzüberzug Aluminiumnitrid- und/oder Diamantpartikel enthalten.

Im Folgenden wird die Erfindung anhand der in der Zeichnung in schematischer Weise dargestellten Ausführungsbeispiele näher erläutert. Es zeigen
- Fig. 1a bis: c eine Seitenansicht und eine Schnittansicht eines Messmoduls mit drei auf einem Kühlkörper angeordneten Spulen, sowie eine Schnittansicht des an ein Wärmerohr angekoppelten Messmoduls;
- Fig. 2: eine Schnittansicht eines Beispiels einer Sensoreinrichtung bei der die Elektronikkomponenten außerhalb des Gehäuses angeordnet sind;
- Fig. 3a: und b eine Darstellung entsprechend Fig. 1a und b mit einer abgewandelten Ausführungsform des Kühlkörpers und einer einzigen Spule;
- Fig. 4: eine Fig. 2 entsprechende Darstellung einer abgewandelten Ausführungsform des Kühlkörpers gemäß der Erfindung mit Spulen in einer Sandwichanordnung;
- Fig. 5a: bis c teilweise geschnittene Seitenansichten eines Messmoduls bei dem ein Koppelelement zwischen dem Kühlkörper und dem Wärmerohr vorgesehen ist:
- Fig. 6a: bis c eine weitere Ausführungsform der Erfindung mit vier Wärmerohren und einem durch Federkraft an den Kühlkörper angekoppelten Spulenverbund; und
- Fig. 7a: bis c eine Seitenansicht und eine Explosionsdarstellung der Ausführungsform gemäß Fig. 6.

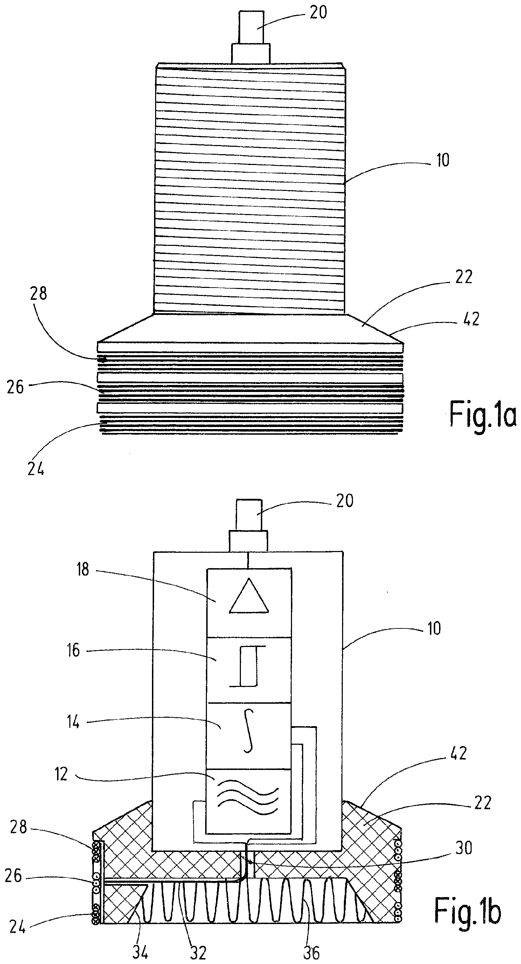

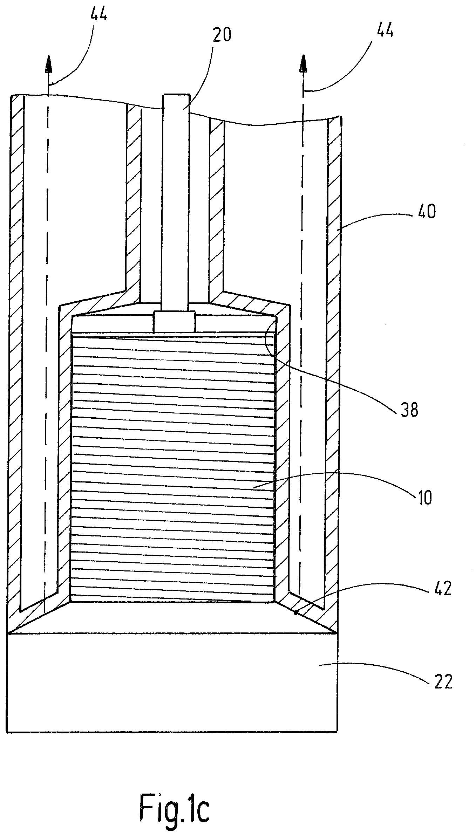

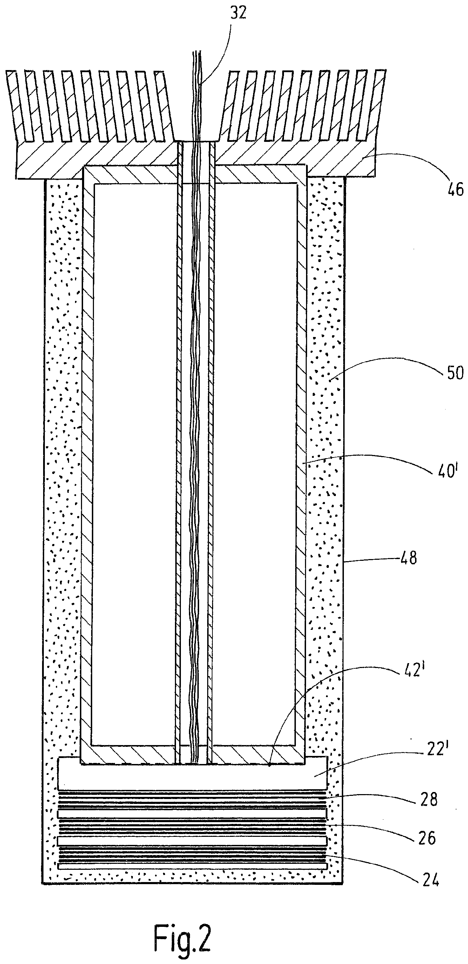

Das in Fig. 1 dargestellte Sensor- oder Messmodul besteht im Wesentlichen aus einem mit einem Außengewinde versehenen Sensorgehäuse 10 aus Messing, in dem die elektronischen Komponenten des Sensors angeordnet sind. Die umfassen einen Oszillator 12, einen Integrator 14, eine Auswerteinheit 16 und einen Verstärker 18. Die Energieversorgung des Sensormoduls und die Messwertabnahme erfolgt über ein aus der Sensoreinrichtung herausgeführtes Sensoranschlusskabel 20. Das Gehäuse 10 ist in einen Kühlkörper 22 eingepasst, der gleichzeitig auf seinem Außenumfang drei Spulen 24, 26, 28 trägt, von denen die mittlere Spule 26 als Sendespule und die äußeren Spulen 24 und 28 als Empfangsspulen ausgebildet sind. Die Spulen 24, 26, 28 sind über durch eine Zentralbohrung 30 geführte Zuführleitungen 32 mit dem Sensormodul verbunden. Der Kühlkörper 22 weist eine bodenseitige, topfförmige Ausnehmung 34 auf, in der thermisches Isolationsmaterial 36 angeordnet ist. Wie der Fig. 1c zu entnehmen ist, ist das Sensormodul in eine zum Gehäuse 10 komplementäre Ausnehmung 38 eines Wärmerohrs 40 eingeschraubt. Die Ausnehmung 38 weist zu diesem Zweck ein dem Außengewinde des Gehäuses 10 entsprechendes Innengewinde auf. Die Wärmeübertragung zwischen dem Kühlkörper 22 und dem Wärmerohr 40 erfolgt über eine Koppelfläche 42 des Kühlkörpers 22. Der Wärmetransport findet von dem warmen Ende der Einrichtung in Richtung der Pfeile 44 zum kalten Ende der Einrichtung statt und wird dort beispielsweise über einen Wärmeableitkörper 46 (Fig. 2) an die Umgebung abgeführt.

Fig. 2 zeigt eine Ausführungsform einer Sensoreinrichtung, bei der die in Fig. 1 dargestellten Elektronikkomponenten nicht unmittelbar an den Kühlkörper anschließen, sondern außerhalb der Sensoreinrichtung vorgesehen sind. Lediglich die Zuführleitungen 32 sind durch das Wärmerohr 40' und den Kühlkörper 22' hindurch zu den Spulen 24, 26, 28 geführt. Die Ankopplung des Kühlkörpers 22' an das Wärmerohr 40' erfolgt mittels einer Lötverbindung über eine im Wesentlichen scheibenförmige Koppelfläche 42'. In dieser Fig. 2 ist weiterhin ein Außengehäuse 48 der Sensoreinrichtung gezeigt, wobei zwischen dem Außengehäuse und dem Wärmerohr 40' hochwirksames Isolationsmaterial 50 vorgesehen ist.

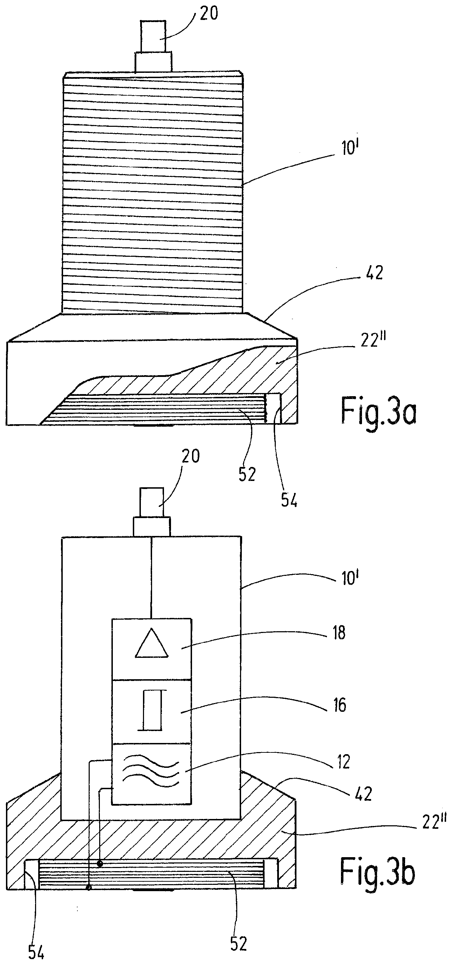

Fig. 3a und b zeigen ein Sensorgehäuse 10' und einen Kühlkörper 22" in einer grundsätzlich den Fig. 1a und b entsprechenden Anordnung. Hier ist jedoch eine einzelne Spule 52 vorgesehen, die zusammen mit den Elektronikkomponenten 12, 16, 18 einen Schwingkreis bildet. Die Spule 52 ist auch nicht auf dem Außenumfang des Kühlkörpers 22" angeordnet, sondern in einer Ringausnehmung 54 in der Unterseite des Kühlkörpers. Das Sensorgehäuse 10' wird wie in Fig. 1c in eine komplementäre Ausnehmung eines Wärmerohrs eingeschraubt, wobei die Wärmeableitung über die Koppelfläche 42 des Kühlkörpers 22" erfolgt.

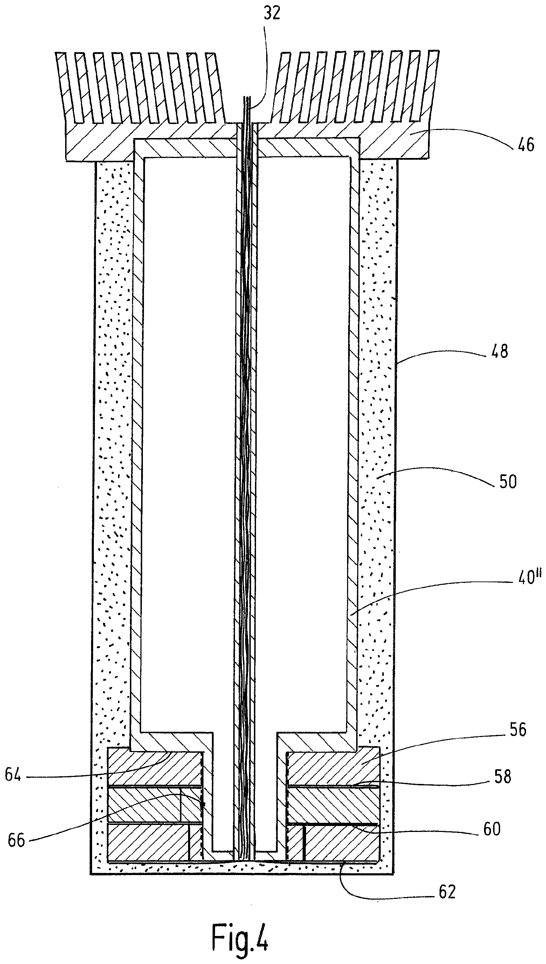

Fig. 4 zeigt eine im Wesentlichen Fig. 2 entsprechende Ausführungsform, das heißt auch hier sind die Elektronikkomponenten 12 bis 18 außerhalb der Sensoreinrichtung angeordnet. Der Kühlkörper 56 ist jedoch gemäß der Erfindung nicht einstückig ausgeführt, sondern besteht aus drei Ringkörpern und es sind drei planare Spulen 58, 60, 62 vorgesehen, die auf bzw. zwischen den Ringkörpern des Kühlkörpers 56 in einer Sandwichbauweise angeordnet sind. Die Verbindung des Kühlkörpers 56 zum Wärmerohr 40" erfolgt mittels einer Lötverbindung entlang der axial und radial orientierten Koppelflächen 64, 66.

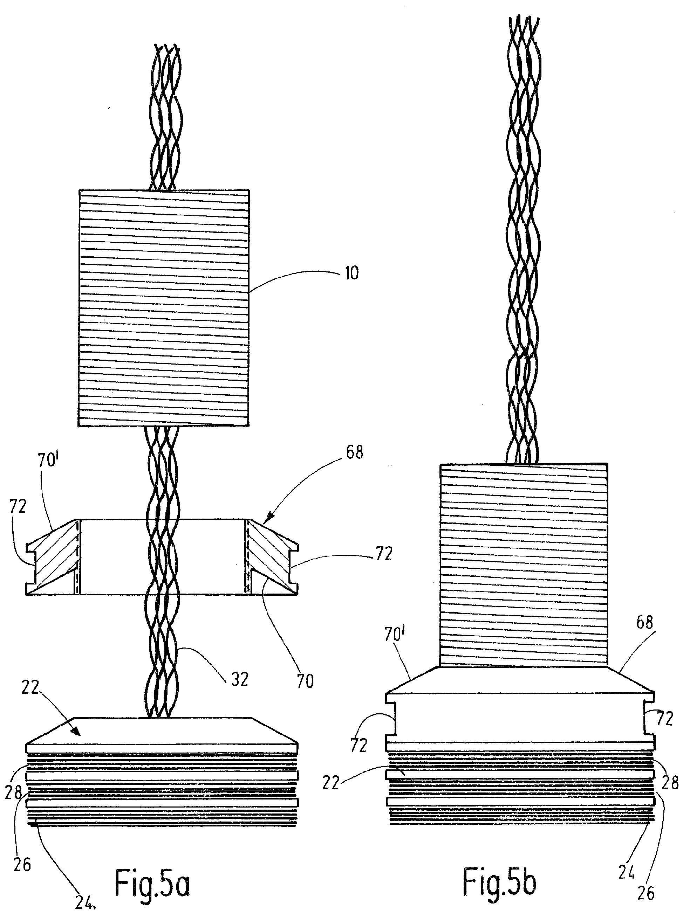

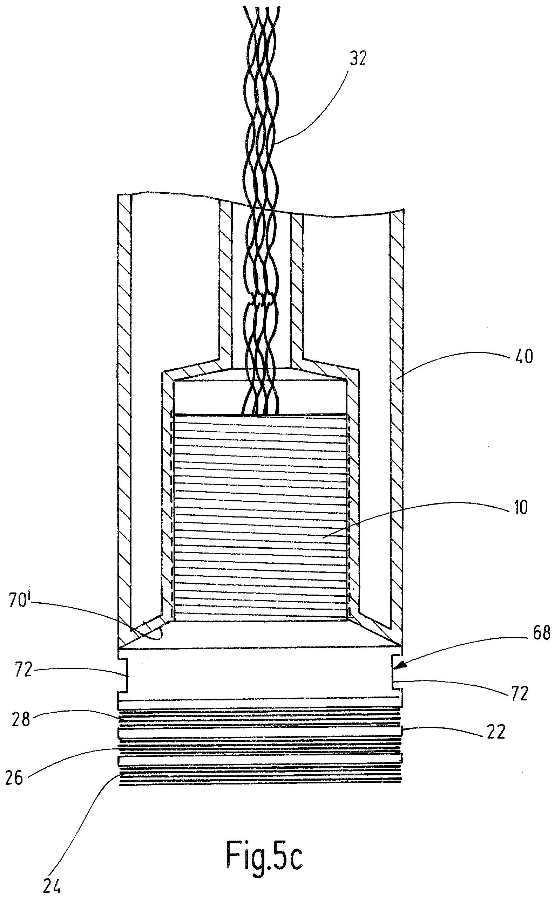

Fig. 5a bis c zeigen eine weitere Ausführungsform, die weitgehend der in Fig. 1a bis c dargestellten entspricht, bei der jedoch zwischen dem Kühlkörper 22 und dem Wärmerohr 40 ein Koppelelement 68 zwischengeordnet ist. Das Koppelelement besteht wie das Wärmerohr aus Kupfer oder einem anderen Metall mit hoher thermischer Leitfähigkeit und weist eine kühlkörperseitige Koppelfläche 70 und eine wärmerohrseitige Koppelfläche 70' auf. Die Verbindung mit dem Kühlkörper 22 erfolgt mittels Löten dauerhaft, während die Ankopplung an das Wärmerohr 40 durch eine Flächenpressung mittels Verschraubung des Verbunds aus Kühlkörper und Koppelelement in das Wärmerohr 40 erfolgt. Das Koppelelement 68 weist Angriffsflächen 72 für ein Werkzeug, beispielsweise einen Maulschlüssel auf. Hierdurch kann die Verschraubung mit höherer Kraft erfolgen, als wenn die Schraubkraft über den Kühlkörper 22 eingeleitet werden würde. Ebenfalls von großem Vorteil ist, dass die Ankopplung des Kühlkörpers 22 an das Wärmerohr nicht dauerhaft über eine Verlötung erfolgt, sondern dass die Sensoreinrichtung auf einfache Weise in die wesentlichen Komponenten zerlegt werden kann, beispielsweise um ein defektes Sensormodul auszutauschen oder ein Sensormodul und/oder Spulenvariante für eine andere Messanordnung zu installieren. Die Verwendung eines entsprechend gestalteten Koppelelements ist selbstverständlich auch bei den Ausführungsformen gemäß Fig. 1 bis 4 möglich.

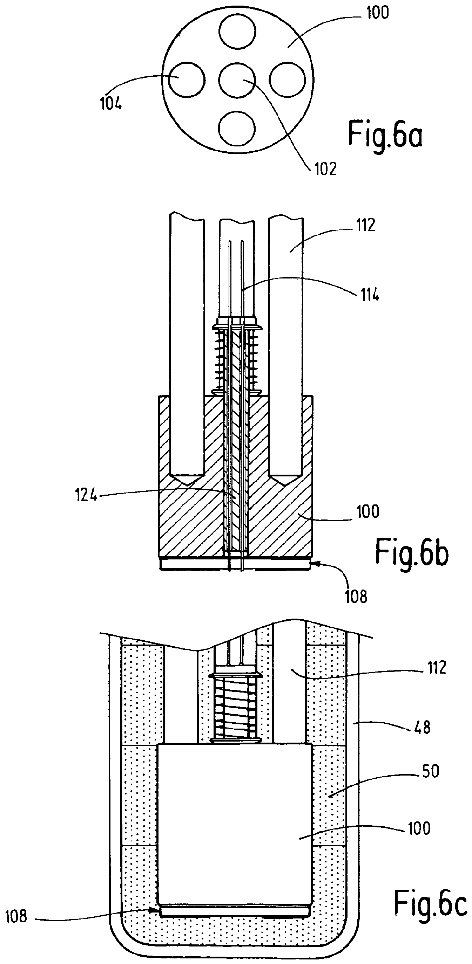

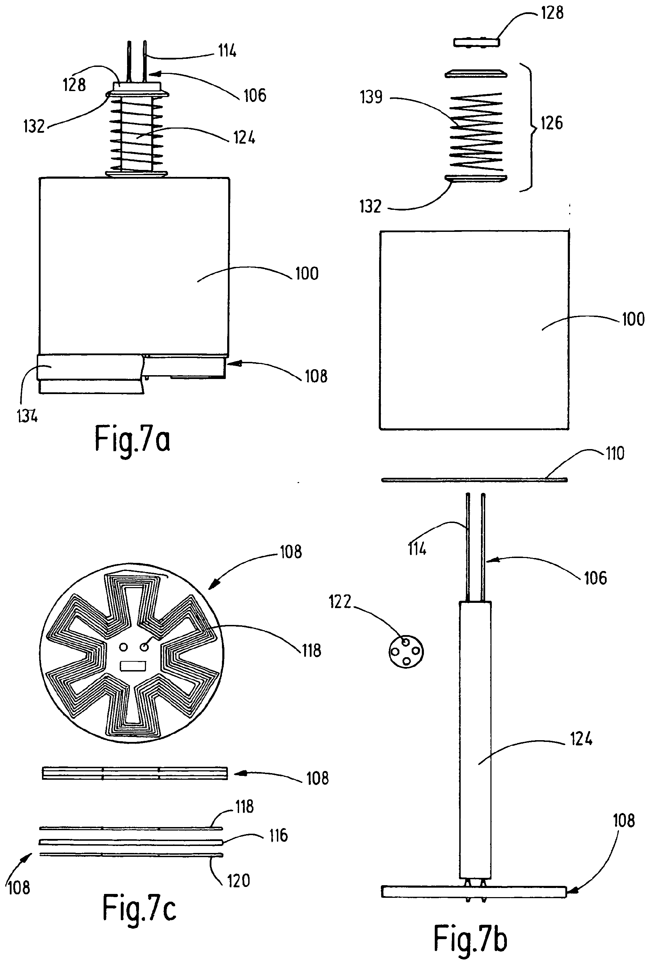

Eine weitere bevorzugte Ausführungsform der Erfindung ist in den Fig. 6 und 7 dargestellt.

Der Kühlkörper 100 dieser Ausführungsform ist im Wesentlichen zylinderförmig (könnte jedoch auch quaderförmig o. dgl. ausgebildet sein) und weist eine zentrale Durchtrittsbohrung 102 und vier dazu symmetrisch angeordnete Sacklöcher 104 auf. Die Durchtrittsbohrung 102 ist für ein Zugorgan 106 bestimmt, mit dem ein Spulenverbund 108 durch Federkraft gegen eine Stirnfläche des Kühlkörpers 100 gepresst wird. Zur Verbesserung der thermischen Ankopplung des Spulenverbunds 108 an den Kühlkörper 100 ist zwischen diesen eine Wärmeleitfolie 110 angeordnet. Die vier Sacklöcher 104 nehmen Endbereiche von Wärmerohren 112 auf, die die vom Kühlkörper 100 aufgenommene Wärme ableiten. Die Kontaktierung zwischen den Wärmerohren 112 und dem Kühlkörper 100 kann durch Schrumpfen, Kleben oder Löten erfolgen.

Das Zugorgan 106 ist durch vier Drahtabschnitte 114 gebildet, die zugleich die elektrischen Zuleitungen von der Sensorelektronik zu dem Spulenverbund 108 darstellen. Der Spulenverbund umfasst wie in Fig. 7c dargestellt ein scheibenförmiges Substrat 116 aus FR4 glasfaserverstärktem Epoxylaminat oder aus Aluminiumnitridkeramik, auf das beidseitig je eine von zwei Kupferspulen 118, 120 im Printverfahren aufgebracht ist. Im mittleren Bereich des Substrats 116 sind vier Bohrungen für den Durchtritt der Drahtabschnitte 114 vorgesehen, die dort mit Kontaktenden der Spulen 118, 120 verlötet sind.

Die vier Drahtabschnitte 114 treten durch Kanäle 122 einer Führungshülse 124 aus Aluminiumoxidkeramik hindurch, die sich zwischen dem Spulenverbund 108 und einem an der gegenüberliegenden Stirnfläche des Kühlkörpers 100 angeordneten Federpaket 126 erstreckt. Abgeschlossen wird die Zugeinrichtung durch eine durchkontaktierte Arretierscheibe 128, mit der die Drahtabschnitte 114 verlötet sind, wobei das Federpaket 126 vorgespannt wird. Das Federpaket 126 umfasst eine Schraubenfeder 130, die endseitig von zwei Scheiben 132 begrenzt wird.

Um ein Eintreten von Partikeln in den Bereich des Spulenverbunds 108 zu verhindern und diesen bei der Montage im Sensorgehäuse 48 vor Verschiebungen zu schützen sind der Spulenverbund 108 und der benachbarte Endbereich des Kühlkörpers 100 mit einem wärmeleitenden Schutzüberzug 134 versehen, der Aluminiumnitrid- und/oder Diamantpartikel enthält.

Bei sämtlichen der vorstehend beschriebenen Ausführungsformen kann der Kühlkörper aus einer Aluminiumnitridkeramik, aus Ferrit, aus einem Verbundwerkstoff aus Ferrit und kohlenstoffhaltigem Material, beispielsweise Graphit, oder aus einem Verbundwerkstoff aus Aluminiumnitrid und Diamant bestehen. Bevorzugt sind solche Materialien, die eine hohe Wärmeleitfähigkeit, Temperaturbelastbarkeit (je nach Einsatztemperatur) und geringe elektrische Leitfähigkeit aufweisen.

Zusammenfassend ist folgendes festzuhalten: Die Erfindung betrifft eine Sensoreinrichtung mit einem Gehäuse 48 für einen mindestens zwei Spulen 58, 60, 62, 118, 120 aufweisenden, vorzugsweise induktiven Sensor 10 zur berührungslosen Abstandsmessung zu elektrisch leitfähigen Objekten, wobei der Sensor eine maximale Betriebstemperatur nicht überschreiten darf. Um die Sensoreinrichtung bei höheren Temperaturen des Messobjekts verwenden zu können, wird gemäß der Erfindung vorgeschlagen, dass in dem Gehäuse ein Kühlkörper 56, 100, 118 einerseits als Träger für die mindestens zwei elektrischen Spulen des Sensors und andererseits als Verbindungselement zu einem Wärmeleitsystem 40", 112 zum Ableiten von Wärme zu einen dem zu messenden Objekt abgewandten Bereich des Gehäuses angeordnet ist.

## Patentansprüche

1. Sensoreinrichtung mit einem Gehäuse (48) für einen mindestens zwei Spulen (58, 60, 62, 118, 120) aufweisenden, vorzugsweise induktiven Sensor (10) zur berührungslosen Abstandsmessung zu elektrisch leitfähigen Objekten, wobei der Sensor eine maximale Betriebstemperatur nicht überschreiten darf, wobei in dem Gehäuse (48) ein Kühlkörper (56, 100, 116) einerseits als Träger für die mindestens zwei elektrischen Spulen des Sensors und andererseits als Verbindungselement zu einem Wärmeleitsystem (40", 112) zum Ableiten von Wärme zu einen dem zu messenden Objekt abgewandten Bereich des Gehäuses (48) angeordnet ist, **dadurch gekennzeichnet dass** der Kühlkörper (56, 100, 116) nicht einstückig ausgeführt ist, sondern aus mindestens zwei Schichten besteht, auf und/oder zwischen denen die mindestens zwei Spulen (58, 60, 62, 118, 120) angeordnet sind.

2. Sensoreinrichtung nach Anspruch 1, **dadurch gekennzeichnet, dass** der Kühlkörper (56, 100, 116) an mindestens ein Wärmerohr (40", 112) angekoppelt ist, welches Wärme vom spulenseitigen Ende des Gehäuses (48) zum dem Objekt abgewandten Ende des Gehäuses transportiert.

3. Sensoreinrichtung nach Anspruch 2, **dadurch gekennzeichnet, dass** der Kühlkörper (56, 100, 116) mittels einer Lötverbindung mit dem mindestens einen Wärmerohr (40", 112) verbunden ist oder dass der Kühlkörper (56, 100, 116) mit einem Koppelelement (68) verbunden ist, das seinerseits mit dem mindestens einen Wärmerohr (40") koppelbar ist, und dass das Koppelelement (68) mit dem mindestens einen Wärmerohr (40") verschraubt oder verrastet ist oder mittels einer Bajonettverbindung verbunden ist.

4. Sensoreinrichtung nach einem der Ansprüche 1 bis 3, **dadurch gekennzeichnet, dass** mindestens eine der Spulen (58, 60, 62, 118, 120) galvanisch mit einer außerhalb des Wärmeleitsystems angeordneten Elektronikeinheit zum Beaufschlagen der mindestens einen Spule mit einer elektrischen Wechselspannung verbunden ist.

5. Sensoreinrichtung nach einem der Ansprüche 1 bis 4, **dadurch gekennzeichnet, dass** der Kühlköper (56, 110, 116) für die Spulen (58, 60, 62, 118, 120) aus einer Aluminiumnitridkeramik oder aus Ferrit oder aus einem Verbundwerkstoff umfassend Ferrit und kohlenstoffhaltiges Material, insbesondere Graphit, besteht.

6. Sensoreinrichtung nach einem der Ansprüche 1 bis 5, **dadurch gekennzeichnet, dass** eine Sendespule und zwei Empfangsspulen zur Anwendung eines Differenzmessverfahrens vorgesehen sind.

7. Sensoreinrichtung nach Anspruch 6, **dadurch gekennzeichnet, dass** die drei Spulen (58, 60, 62) axial in der Reihenfolge Empfangsspule-Sendespule-Empfangsspule angeordnet sind.

8. Sensoreinrichtung nach einem der Ansprüche 1 bis 5, **gekennzeichnet durch** zwei ringförmig geschlossene Mäanderspulen (118, 120), die hinsichtlich ihrer Mäander deckungsgleich oder um einen Winkel zueinander versetzt angeordnet sind.

9. Sensoreinrichtung nach Anspruch 8, **dadurch gekennzeichnet, dass** die zwei Spulen (118, 120) als Kupferprintspulen auf je einer Seite eines scheibenförmigen Kunststoffsubstrats (116), vorzugsweise eines FR4 glasfaserverstärkten Epoxylaminatsubstrats, oder eines Aluminiumnitrid Keramiksubstrats ausgebildet sind.

10. Sensoreinrichtung nach einem der Ansprüche 1 bis 3 oder 8 und 9, **dadurch gekennzeichnet, dass** der Kühlkörper (100) eine zentrale Durchtrittsbohrung (102) aufweist, durch die ein federbelastetes Zugorgan (106) hindurchtritt, das einen aus zwei je auf einer Seite eines Substrats (116) angeordneten Spulen (118, 120) bestehenden Spulenverbund (108) gegen eine Stirnfläche des Kühlkörpers (100) drückt.

11. Sensoreinrichtung nach Anspruch 10, **dadurch gekennzeichnet, dass** der Kühlkörper (100) eine Mehrzahl von die Durchtrittsbohrung (102) umgebende, vorzugsweise als Sacklöcher ausgebildete Bohrungen (104) zur Aufnahme von Wärmerohren (112) aufweist und dass zwischen dem Spulenverbund (108) und dem Kühlkörper (100) eine Wärmeleitfolie (110) angeordnet ist.

12. Sensoreinrichtung nach Anspruch 10 oder 11, **dadurch gekennzeichnet, dass** das Zugorgan (106) durch vier Drahtabschnitte (114) gebildet ist, die durch den Spulenverbund (108) hindurchtreten und mit Anschlüssen der zwei Spulen (118, 120) elektrisch kontaktiert sind.

13. Sensoreinrichtung nach Anspruch 12, **dadurch gekennzeichnet, dass** die dem Spulenverbund (108) abgewandten Enden der vier Drahtabschnitte (114) unter Zwischenschaltung eines Federpakets (126) durch eine Arretierscheibe (128) hindurchtreten und mit dieser verbunden, vorzugsweise verlötet, sind.

14. Sensoreinrichtung nach einem der Ansprüche 10 bis 13, **dadurch gekennzeichnet, dass** der Kühlkörper (100) aus Aluminiumnitridkeramik besteht.

## Claims

1. A sensor device comprising a housing (48) for a preferably inductive sensor (10) having at least two coils (58, 60, 62; 118, 120) for contactless distance measurement to electrically conductive objects, wherein the sensor may not exceed a maximum operating temperature, wherein a heat sink (56, 100, 116) is disposed in the housing (48) on the one hand as a carrier for the at least two electrical coils of the sensor and, on the other hand, as a connecting element to a heat conduction system (40", 112) to dissipate heat to a region of the housing (48) facing away from the object to be measured, **characterized in that** the heat sink (56, 100, 116) is not one continuous part but consists of at least two layers, on and/or between which the at least two coils (58, 60, 62, 118, 120) are disposed.

2. Sensor device according to claim 1, **characterized in that** the heat sink (56, 100, 116) is coupled to at least one heat pipe (40", 112) which transfers heat from the coil end of the housing (48) to the end of the housing remote from the object.

3. Sensor device according to claim 2, **characterized in that** the heat sink (56, 100, 116) is connected to the at least one heat pipe (40", 112) by means of a soldering connection, or that the heat sink (56, 100, 116) is connected to a coupling element which in turn can be coupled to the at least one heat pipe (40"), and that the coupling element (68) is screwed or locked to the at least one heat pipe (40") or is connected by means of a bayonet connection.

4. Sensor device according to one of claims 1 to 3, **characterized in that** the at least one of the coils (62, 118, 120) is galvanically connected to an electronic unit arranged outside the heat conducting system for applying an electrical alternating voltage to the at least one coil.

5. Sensor device according to one of claims 1 to 4, **characterized in that** the heat sink (56, 110, 116) for the coils (58, 60, 62, 118, 120) consists of an aluminum nitride ceramic or of ferrite or of a composite material comprising ferrite and carbonaceous material, in particular graphite.

6. Sensor device according to one of claims 1 to 5, **characterized in that** one transmitting coil and two receiving coils are provided for applying a difference measuring method.

7. Sensor device according to claim 6, **characterized in that** the three coils (58, 60, 62) are arranged axially in the order of the receiving coil, transmitting coil, receiving coil.

8. Sensor device according to one of claims 1 to 5, **characterized by** two annularly closed meandering coils (118, 120), which are arranged with respect to their meanders covering each other or offset at an angle to each other.

9. Sensor device according to claim 8, **characterized in that** the two coils (118, 120) are designed as copper-printed coils on each side of a disc-shaped plastic substrate (116), preferably a FR4 glass-fiber-reinforced epoxy laminate substrate, or an aluminum nitride ceramic substrate.

10. Sensor device according to one of claims 1 to 3 or 8 and 9, **characterized in that** the heat sink (100) has a central through-bore (102) through which a spring-loaded tensioning element (106) passes which presses a coil assembly (108) consisting of two coils (118, 120) arranged each on one side of a substrate (116) against an end face of the heat sink (100).

11. Sensor device according to claim 10, **characterized in that** the heat sink (100) comprises a plurality of bores (104) preferably formed as blind holes for accommodating heat pipes (112) surrounding the through-bore (102) and that a heat conducting foil (110) is disposed between the coil assembly (108) and the heat sink (100).

12. Sensor device according to claim 10 or 11, **characterized in that** the tensioning element (106) is formed by four wire sections (114) which pass through the coil assembly (108) and are electrically contacted with connectors of the two coils (118, 120).

13. Sensor device according to claim 12, **characterized in that** the ends of the four wire sections (114) facing away from the coil assembly (108) pass through a locking disc (128) with a set of springs (126) inbetween and are connected, preferably soldered, thereto.

14. Sensor device according to one of claims 10 to 13, **characterized in that** the heat sink (100) consists of an aluminum nitride ceramic.

## Revendications

1. Dispositif capteur avec un logement (48) pour un capteur (10), de préférence inductif, présentant au moins deux bobines (58, 60, 62, 118, 120) en vue de la mesure sans contact d'un écartement par rapport à des objets électriquement conducteurs, dans lequel le capteur n'est pas censé dépasser une température opérationnelle maximale, dans lequel dans le logement (48) un corps de refroidissement (56, 100, 116) est disposé d'une part en tant que support pour les au moins deux bobines électriques du capteur et d'autre part en tant qu'élément de liaison à un système conducteur de chaleur (40", 112) pour détourner de la chaleur vers une zone du logement (48) opposée à l'objet à mesurer, **caractérisé en ce que** le corps de refroidissement (56, 100, 116) n'est pas réalisé d'un seul tenant mais se compose plutôt d'au moins deux couches, sur et/ou entre lesquelles sont disposées les au moins deux bobines (58, 60, 62, 118, 120).

2. Dispositif capteur selon la revendication 1, **caractérisé en ce que** le corps de refroidissement (56, 100, 116) est couplé à au moins un tuyau de chaleur (40", 112), lequel transporte de la chaleur d'une extrémité du logement (48) côté bobine à l'extrémité du logement opposée à l'objet.

3. Dispositif capteur selon la revendication 2, **caractérisé en ce que** le corps de refroidissement (56, 100, 116) est relié à l'au moins un tuyau de chaleur (40", 112) au moyen d'une liaison soudée ou **en ce que** le corps de refroidissement (56, 100, 116) est relié à un élément de couplage (68) qui peut être couplé d'une part à l'au moins un tube de chaleur (40") et **en ce que** l'élément de couplage (68) est vissé ou encliqueté ou est relié au moyen d'une liaison à baïonnette avec l'au moins un tuyau de chaleur (40").

4. Dispositif capteur selon l'une des revendications 1 à 3, **caractérisé en ce qu'**au moins l'une des bobines (58, 60, 62, 118, 120) est reliée par voie galvanique avec une unité électronique disposée à l'extérieur du système conducteur de chaleur en vue de l'alimentation de l'au moins une bobine avec une tension électrique alternative.

5. Dispositif capteur selon l'une des revendications 1 à 4, **caractérisé en ce que** le corps de refroidissement (56, 110, 116) pour les bobines (58, 60, 62, 118, 120) se compose d'une céramique de nitrure d'aluminium ou de ferrite ou d'un matériau composite comprenant de la ferrite et un matériau contenant du carbone, en particulier le graphite.

6. Dispositif capteur selon l'une des revendications 1 à 5, **caractérisé en ce qu'**une bobine d'envoi et deux bobines de réceptions sont prévues pour l'application d'un procédé de mesure de différences.

7. Dispositif capteur selon la revendication 6, **caractérisé en ce que** les trois bobines (58, 60, 62) sont disposées axialement dans l'ordre bobine de réception-bobine d'envoi-bobine de réception.

8. Dispositif capteur selon l'une des revendications 1 à 5, **caractérisé par** deux bobines à méandres (118, 120) fermées pour former un anneau qui sont disposées de manière à se chevaucher en ce qui concerne leurs méandres ou décalées l'une par rapport à l'autre selon un angle.

9. Dispositif capteur selon la revendication 8, **caractérisé en ce que** les deux bobines (118, 120) sont configurées en tant que bobines à empreinte de cuivre sur une face respective d'un substrat en matière plastique en forme de disque (116), de préférence d'un substrat de laminé époxy renforcé en fibres de verre FR4, ou d'un substrat en céramique de nitrure d'aluminium.

10. Dispositif capteur selon l'une des revendications 1 à 3 ou 8 et 9, **caractérisé en ce que** le corps de refroidissement (100) présente un alésage traversant central (102) à travers lequel passe un organe de traction à effet ressort (106) qui pousse un composite de bobines (108) se composant de deux bobines (118, 120) disposées sur une face respective d'un substrat (116) contre une surface frontale du corps de refroidissement (100).

11. Dispositif capteur selon la revendication 10, **caractérisé en ce que** le corps de refroidissement (100) présente une pluralité d'alésages (104) entourant l'alésage traversant (102), de préférence configurés en tant que trous borgnes pour la réception de tuyaux de chaleur (112), et **en ce que**, entre le composite de bobines (108) et le corps de refroidissement (100) est disposée une feuille conductrice de chaleur (110).

12. Dispositif capteur selon la revendication 10 ou 11, **caractérisé en ce que** l'organe de traction (106) est formé par le biais de quatre segments de fil (114) qui passent à travers le composite de bobines (108) et sont mis en contact électrique avec les bornes des deux bobines (118, 120).

13. Dispositif capteur selon la revendication 12, **caractérisé en ce que** les extrémités des quatre segments de fil (114), opposées au composite de bobines (108), passent à travers un disque d'arrêt (128) en intercalant un groupe de ressorts (126) et sont reliées à ce disque, de préférence soudées.

14. Dispositif capteur selon l'une des revendications 10 à 13, **caractérisé en ce que** le corps de refroidissement (100) se compose d'une céramique de nitrure d'aluminium.
